Europäisches Patentamt

European Patent Office

Office européen des brevets

(11) Numéro de publication: **0 037 764**
**B1**

# FASCICULE DE BREVET EUROPEEN

(45) Date de publication du fascicule du brevet:
22.08.84

(51) Int. Cl.³: **H 01 L 29/06, H 01 L 29/91, H 01 L 29/78, H 01 L 21/74**

(21) Numéro de dépôt: **81400444.6**

(22) Date de dépôt: **20.03.81**

(54) Structure de dispositif à semiconducteur à anneau de garde, et à fonctionnement unipolaire.

(30) Priorité: **04.04.80 FR 8007649**

(43) Date de publication de la demande:
**14.10.81 Bulletin 81/41**

(45) Mention de la délivrance du brevet:
**22.08.84 Bulletin 84/34**

(84) Etats contractants désignés:
**DE FR GB IT NL**

(56) Documents cités:
**FR - A - 2 098 319**
**US - A - 3 909 119**
**US - A - 3 995 301**
**US - A - 4 110 775**
**US - A - 4 145 700**

**NEUES AUS DER TECHNIK, no. 6, 1 décembre 1976 WURZBURG, DE "Doppelt diffundierte MOS-Transistoren (D-MOST oder DSA-MOST)" page 1**
**PATENTS ABSTRACTS OF JAPAN, vol. 3, no. 30, 13 mars 1979, page 34 E 97 Tokyo, JP**
**PATENTS ABSTRACTS OF JAPAN, vol. 3, no. 46, 20 avril 1979, page 88 E 105 Tokyo, JP**
**ELECTRONIC DESIGN, vol. 27, 20 décembre 1979, no. 26, Rochelle Park, US G. HEFTMAN: "Vertical DMOS makes a bid for MOS processing leaderships", pages 27-28**

(73) Titulaire: **THOMSON-CSF, 173, Boulevard Haussmann, F-75379 Paris Cedex 08 (FR)**

(72) Inventeur: **Tonnel, Eugène, THOMSON-CSF SCPI 173, bld Haussmann, F-75360 Paris Cedex 08 (FR)**

(74) Mandataire: **de Beaumont, Michel et al, THOMSON-CSF SCPI 173, Bld Haussmann, F-75379 Paris Cedex 08 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne une structure de dispositif semiconducteur à anneau de garde à fonctionnement unipolaire et plus particulièrement une telle structure permettant d'améliorer la tenue en tension et en courant d'un dispositif de ce type.

De façon générale, dans un dispositif à semiconducteur de type planar, il est connu que, dans de nombreux cas, il est souhaitable d'entourer la structure d'un composant individuel, éventuellement inséré dans un circuit intégré, d'un anneau de garde pour éleminer ou réduire les phénomènes parasites liés aux effets de bords des jonctions planar.

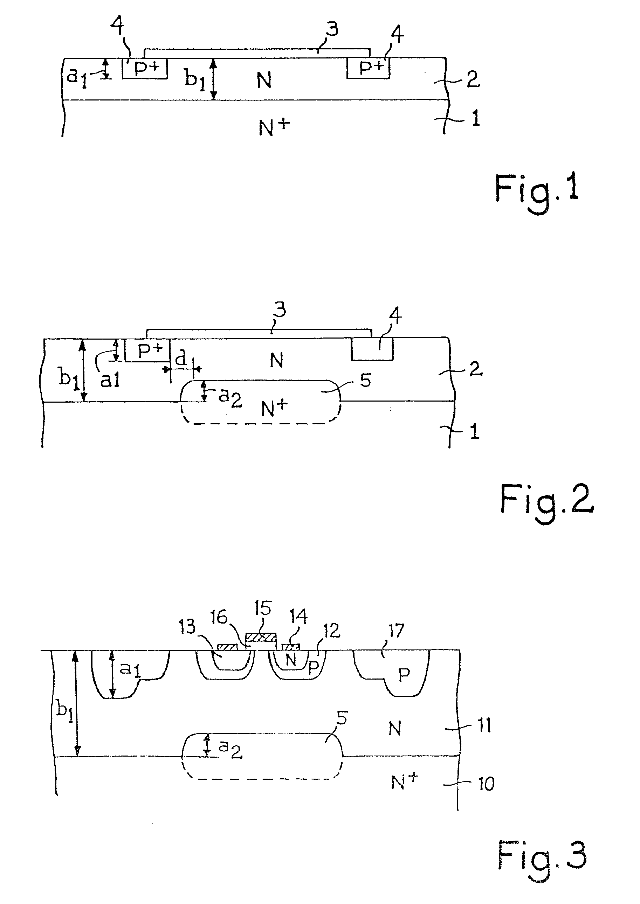

La figure 1 représente à titre d'exemple une diode Schottky à anneau de garde. Cette diode comprend, sur un substrat 1 de type $N^+$, une couche épitaxiée 2 de type N. L'effet Schottky se produit à l'interface entre une métallisation 3 d'un matériau sélectionné et la couche épitaxiée 2. Un anneau de garde 4 de type $P^+$ obtenue de façon générale par diffusion ou implantation/diffusion entoure la zone utile de cette diode et est en contact avec la métallisation 3.

Les avantages d'une telle structure sont par exemple décrits dans l'article de M.P. Lepselter paru dans the Bell System Technical Journal de février 1968 pages 195 à 208. Il est également rappelé dans cet article qu'une diode Schottky est un dispositif à fonctionnement de type unipolaire.

L'une des conséquences de ce type de fonctionnement est que la résistance à l'état passant d'un tel dispositif est une fonction directe de l'épaisseur $b_1$ de la couche épitaxiée. Ainsi, quand on prévoit un anneau de garde, on est amené à augmenter cette épaisseur $b_1$ donc à augmenter la chute de tension en direct de ce dispositif, c'est-à-dire à augmenter l'échauffement du composant pour des valeurs du courant élevées. Si l'on désigne par $a_1$ la profondeur de l'anneau de garde, on peut donc dire de façon schématique que la chute de tension en direct du dispositif est fonction de l'épaisseur de la couche épitaxiée $b_1$ alors que sa tenue en tension est fonction de l'épaisseur de la couche épitaxiée restante sous l'anneau de garde, c'est-à-dire $b_1 - a_1$.

Ainsi, pour permettre d'obtenir un dispositif unipolaire, par exemple une diode de Schottky présentant à la fois une bonne tenue en courant direct et une bonne tenue en tension inverse, on est amené à limiter la profondeur de l'anneau de garde. Une telle approche a été réalisée dans la technique antérieure en utilisant, au lieu d'un anneau de garde unique d'une profondeur donnée, plusieurs anneaux de garde successifs de profondeur moindre procurant une répartition équivalente des lignes de champ. L'inconvénient évident du choix d'une telle structure est qu'elle occupe une surface de semiconducteur, couramment du silicium, plus importante. Cet inconvénient est particulièrement gênant dans le cas des circuits intégrés où l'on tend à une miniaturisation aussi grande que possible des dimensions de chaque composant élémentaire.

Ainsi, un objet de la présente invention est de prévoir une nouvelle structure du dispositif à semiconducteur à anneau de garde et à fonctionnement unipolaire permettant une amélioration simultanée en tension inverse et de la chute de tension en direct n'entraînant pas d'augmentation des dimensions superficielles d'un composant élémentaire.

Un autre objet de la présente invention est de prévoir un mode de fabrication particulier d'une telle structure qui soit particulièrement simple et économique.

Pour atteindre ces objets ainsi que d'autres, la présente invention se base sur l'analyse théorique énoncée ci-dessus des facteurs influant sur la tenue en tension inverse et la tenue en courant direct dans un dispositif à semiconducteur à anneau de garde et à fonctionnement de type unipolaire en notant qu'il n'y a en fait pas contradiction entre une réduction de la distance $b_1$ et l'augmentation de la distance $b_1 - a_1$, du fait que la distance $b_1 - a_1$ qui intervient pour la détermination de la tenue en tension est celle de la couche épitaxiée sous l'anneau de garde alors que la distance $b_1$ qui intervient pour la tenue en courant est l'épaisseur de la couche épitaxiée sous la zone active du composant. Ainsi, l'invention prévoit de laisseur une hauteur moins importante de couche épitaxiée à faible niveau de dopage sous la partie active du composant que sous l'anneau de garde. En d'autres termes, la présente invention prévoit un dispositif à semiconducteur à fonctionnement unipolaire formé dans une couche épitaxiée d'un premier type de conductivité déposée sur un substrat du même type de conductivité mais à niveau de dopage plus élevé et entouré d'un anneau de garde d'une profondeur supérieure à celle des jonctions les plus profondes de ce dispositif, comprenant sous la partie active une zone de même type de conductivité que celui du substrat et à plus fort niveau de dopage en relief par rapport à l'interface substrat/couche épitaxiée et s'étendant dans cette dernière selon une épaisseur du même ordre de grandeur que la profondeur de l'anneau de garde: tout en restant, en projection, avec sa limite latérale externe à une distance par rapport avec la limité latérale interne de l'anneau de garde d'au moins de l'ordre de grandeur de l'épaisseur de la couche épitaxiée.

La présente invention prévoit également un procédé de réalisation d'une telle structure selon lequel, avant l'élaboration de la couche épitaxiée, il est prévu d'implanter dans le substrat, selon une concentration importante, un dopant du même type de conductivité que celui du substrat et celui de la couche épitaxiée, puis de faire diffuser les éléments dopants contenus dans cette couche enterrée en direction de la couche épitaxiée après l'élaboration de celle-ci, et éventuellement en même temps que l'étape de pénétration par diffusion de l'anneau de garde.

Ces objets, caractéristiques et avantages ainsi que d'autres de la présente invention seront exposés plus en détail dans la description suivante de modes de réalisation particuliers, faite en relation avec les figures jointes parmi lesquelles:

la figure 1 a été décrite précédemment et est destinée à servir de support à la description de l'état de la technique;

la figure 2 illustre une application de la présente invention à la réalisation d'une diode Schottky de puissance à anneau de garde;

la figure 3 illustre une application de la présente invention à la réalisation d'un dispositif à effet de champ à anneau de garde.

De façon générale, on notera que, comme cela est classique dans le domaine des semiconducteurs, les figures ne sont pas tracées à l'échelle et sont fortement schématiques, les dimensions latérales ou longitudinales de certaines zones ou couches étant dilatées pour mieux faire ressortir certaines caractéristiques des dispositifs considérés.

La figure 2 représente une structure de diode Schottky selon la présente invention. Cette diode comprend comme cela est illustré en figure 1, un substrat de type $N^+$ revêtu d'une couche épitaxiale 2, une métallisation 3 présentant une barrière Schottky avec la couche épitaxiale 2 et un anneau de garde 4 périphérique. Il est bien entendu d'ailleurs que le terme anneau de garde n'implique pas nécessairement que la structure est à géométrie circulaire. Elle peut bien entendu, selon le cas, être de toute configuration polygonale ou digitée. Comme dans le cas précédent, l'épaisseur de la couche épitaxiée est désignée par la valeur $b_1$ et la profondeur de l'anneau de garde par la valeur $a_1$. Dans le cas de la figure 2, l'interface entre la zone 1 à haut niveau de dopage et la couche épitaxiée 2 à plus faible niveau de dopage, au lieu d'être plane présente des remontées dans les parties qui ne sont pas situées sous l'anneau de garde, c'est-à-dire sous la partie active de la diode Schottky. Si l'on désigne par $a_2$ la hauteur dont la couche à haut niveau de dopage pénètre dans la couche 2 à plus faible niveau de dopage, on notera que, maintenant, la tenue en tension inverse est déterminée par la valeur de $b_1 - a_1$ alors que la chute de tension en direct est déterminée par la valeur de $b_1 - a_2$. Ainsi, ces deux paramètres peuvent être réglés de façon sensiblement indépendante. La hauteur dont la zone à plus haut niveau de dopage remonte sous la diode Schottky pourra être choisie du même ordre de grandeur que la profondeur de l'anneau de garde. On pourra par exemple choisir $a_2 = 0,8\ a_1$. La profondeur de l'anneau de garde pourra être choisie sensiblement égale à la moitié de l'épaisseur de la couche épitaxiée, c'est-à-dire $b_1 \# 2a_1$. La distance en projection entre la limite latérale externe de la couche 5 et la limite latérale interne de l'anneau de garde devra être au moins de l'ordre de grandeur de l'épaisseur de la couche épitaxiée.

Dans une réalisation pratique de diode Schottky, on pourra choisir un substrat de type $N^+$ d'une épaisseur de l'ordre de 200 microns et une épaisseur de couche épitaxiée de l'ordre de 5 à 10 microns ce qui fournit un dispositif ayant une tenue en tension inverse de 40 à 100 volts et admettant un courant direct de l'ordre de 10 à 30 ampères/mm$^2$.

Parmi les divers procédés de réalisation possibles d'une structure telle que celle illustrée en figure 2, celui qui semble actuellement préférable à la Demanderesse consiste à prévoir les étapes suivantes:

— implanter dans le substrat 1, de type $N^+$, dopé par exemple à l'antimoine des atomes de phosphore conférant également le type de conductivité N selon une concentration relativement importante et sensiblement aux emplacements devant être occupés par la couche 5 (en tenant compte de l'extension ultérieure liée à la diffusion);

— former la couche épitaxiale 2;

— former l'anneau de garde 4, par exemple par implantation ou prédépôt;

— procéder à une étape thermique pour obtenir la diffusion simultanée de l'anneau de garde 4 et de la couche implantée dans la couche épitaxiée 2.

La largeur d représentant la distance latérale entre la zone d'implantation (5) de type $N^+$ et la zone d'implantation de la couche 4 de type $P^+$ sera choisie par exemple de l'ordre de 2 $b_1$.

La figure 3 représente une autre application de la présente invention pour un dispositif à fonctionnement unipolaire du type transistor à effet de champ. Le transistor à effet de champ particulier représenté est un transistor obtenu par double diffusion et à fonctionnement vertical. Il est élaboré sur un substrat de type $N^+$ 10 revêtu d'une couche épitaxiale 11 de type N. Il est d'abord formé dans cette couche épitaxiée des zones de type P 12 correspondant à la zone intermédiaire des transistors à effet de champ, puis à l'intérieur de ces zones 12, des zones 13 de type N sur lesquelles sont formées des métallisations de source 14. Au-dessus des parties de la zone intermédiaire 12 correspondant aux emplacement où l'on veut former le canal, est déposée une métallisation de grille 15 au-dessus d'une couche mince isolante 16, par exemple de la silice ou du nitrure de silicium. En même temps que la couche intermédiaire 12 est formé un anneau de garde 17. La structure décrite jusqu'à présent est relativement classique et peut s'accomoder de nombreuses variantes. Comme dans le cas de la figure 2, la présente invention vise la formation d'une couche 5 pénétrant d'une hauteur $a_2$ dans la couche épitaxiée 11 de type N, cette couche étant dopée de type $N^+$ avec un fort niveau de concentration de dopant. On désigne comme précédemment par $b_1$ l'épaisseur de la couche épitaxieé et par $a_1$ l'épaisseur maximale de l'anneau de garde. Le drain du transistor à effet de champ est repris sur la face inférieure du substrat $N^+$ 10 ou bien, comme cela est également classique, ce contact de drain est remonté sur la face supérieure du transistor à l'aide de puits de type $N^+$ non représentés. La prévision de la couche de type 5 permet de régler indépendamment la tenue en tension drain-source du transistor à effet de champ qui dépend de la valeur

$b_1 - a_1$ et la résistance de drain qui dépend de la valeur $b_1 - a_2$.

Comme dans le cas de la figure 2, la couche à niveau de dopage élevé 5 sera de préférence obtenue par implantation initiale d'une couche enterrée dans le substrat 10, formation d'une couche épitaxiée, puis diffusion vers le haut des dopants enterrés.

Dans un cas pratique, si l'on considère un dispositif présentant une épaisseur de couche épitaxiée de l'ordre de 5 à 50 microns, on pourra obtenir une tenue en tension de l'ordre de 60 à 1000 volts permettant de laisser passer un courant drain-source de l'ordre de 10 à 100 ampères, en choisissant bien entendu, de façon convenable, mais classique, les autres paramètres du dispositif.

Il convient d'insister sur le fait que deux structures particulières des dispositifs à fonctionnement unipolaire ont été plus spécifiquement décrites en relation avec les figures 2 et 3 mais que la présente invention pourra s'appliquer à d'autres types de dispositifs semiconducteurs à fonctionnement unipolaire, tels que des transistors à effet de champ de type autre que le dispositif D MOS représenté, dans lesquels on veut obtenir à la fois une tenue en tension et une tenue en courant importantes.

Il convient également d'insister sur le fait que la couche enterrée prévue dans la présente invention pour des dispositifs à fonctionnement de type unipolaire qui a essentiellement pour rôle de réduire la résistance s'opposant au passage des porteurs majoritaires n'a pas la même fonction que la couche enterrée généralement prevue dans les structures integrées comprenant des dispositifs de type bipolaire; dans ce cas, la couche enterrée de type opposé à celui du substrat assure l'isolement des composants bipolaire contenus dans les caissons élémentaires. En effet, dans le cas des dispositifs à fonctionnement bipolaire, qui font intervenir une circulation de porteurs minoritaires et majoritaires, la résistance électrique apparente externe est moins directement liée à l'épaisseur de la couche épitaxiée à faible niveau de dopage, cette résistance étant modulée.

**Revendications**

1. Dispositif à semiconducteur à fonctionnement unipolaire formé dans une couche épitaxiée (2) d'un premier type de conductivité déposée sur un substrat (1) du même type de conductivité mais à niveau de dopage plus élevé, et entouré d'un anneau de garde (4) d'une profondeur $(a_1)$ supérieure à celle des jonctions les plus profondes de ce dispositif, caractérisé en ce qu'il comprend, sous la partie active, une zone (5) en relief par rapport à l'interface substrat-couche épitaxiée, du même type de conductivité que celui du substrat et à plus fort niveau de dopage, cette zone s'étendant dans la couche épitaxiée selon une épaisseur du même ordre de grandeur que la profondeur de l'anneau de garde. Tout en restant, en projection, avec sa limite latérale externe à une distance (d) par rapport avec la limite latérale interne de l'anneau de garde (4) d'au moins de l'ordre de grandeur de l'épaisseur de la couche épitaxiée (2).

2. Dispositif selon la revendication 1, caractérisé en ce qu'il est du type diode Schottky.

3. Dispositif selon la revendication 1, caractérisé en ce qu'il est tu type transistor à effet de champ à fonctionnement vertical.

4. Procédé de fabrication d'un dispositif selon la revendication 1, caractérisé en ce qu'il comprend les étapes suivantes:

– implantation dans le substrat d'atomes dopants du même type de conductivité que ce substrat, sous les parties actives,

– formation d'une couche épitaxiée,

– puis diffusion dans la couche épitaxiée des atomes dopants implantés.

**Patentansprüche**

1. Halbleitervorrichtung mit einpoliger Arbeitsweise, die in einer epitaxialen Schicht (2) mit einem ersten spezifischen Leitwert gebildet ist, welche auf ein Substrat (1) mit dem gleichen spezifischen Leitwert aber mit einem höheren Dotierungsniveau aufgetragen ist, und mit einem eine grössere Tiefe $(a_1)$ als die der tiefsten Übergangszone dieser Vorrichtung aufweisenden Schutzring (4) umgeben ist, dadurch gekennzeichnet, dass er unter dem aktiven Teil eine im Verhältnis zur Grenzfläche zwischen dem Substrat und der epitaxialen Schicht erhabene Zone (5) mit gleichem spezifischen Leitwert wie das Substrat und mit einem höherem Dotierungsniveau umfasst, wobei diese Zone sich in der epitaxialen Schicht mit einer Dicke der selben Grössenordnung wie die Tiefe des Schutzringes erstreckt und dabei A) in Projektionsansicht der äusseren seitlichen Begrenzung sich in einem Abstand (d) von wenigstens der Grössenordnung der Dicke der epitaxialen Schicht (2) im Verhältnis zu der seitlichen inneren Begrenzung des Schutzringes (4) befindet.

2. Vorrichtung nach Anspruch 1, dadurch gekennzeichnet, dass sie dem Schottky-Diodentyp angehört.

3. Vorrichtung nach Anspruch 1, dadurch gekennzeichnet, dass sie dem Feldeffekt-Transistortyp mit senkrechter Arbeitsweise angehört.

4. Herstellungsverfahren einer Vorrichtung nach Anspruch 1, dadurch gekennzeichnet, dass es die folgenden Verfahrensschritte umfasst:

– Implantierung unter die aktiven Teile von dotierenden Atomen mit gleichem spezifischen Leitwert wie dieses Substrat,

– Bildung einer epitaxialen Schicht,

– dann Diffusion von implantierten dotierenden Atomen in der epitaxialen Schicht.

**Claims**

1. Unipolar operating semiconductor device formed in an epitaxied layer of a first type of conductivity deposited on a substrate (1) of the same type of conductivity but at a higher doping level, and surrounded by a protection ring (4) having a depth $(a_1)$ superior to that of the deepest functions of this device, characterized in that it comprises, under the active part, a zone (5) in relief with respect to the epitaxied substrate-layers interface of the same type of conductivity as that of the substrate and at a stronger level of doping, this zone extending in the epitaxied layer according to a thickness of about the same importance as the width of the protection ring, while remaining, in projection, with its external lateral limit at a distance (d) with respect to the internal lateral limit of the protection ring (4) of at least about the importance of the thickness of the epitaxial layer (2).

2. Device according to claim 1, characterized in that it is of the Schottky type diode.

3. Device according to claim 1, characterized in that it is of the vertical operating field effect type transistor.

4. Process for manufacturing a device according to claim 1, characterized in that it comprises the following steps:

– implantation in the substrate of doping atoms of the same type of conductivity as this substrate, underneath the active parts,

– formation of an epitaxied layer,

– then diffusion in the epitaxy layer of implanted doping atoms.

Fig.1

Fig.2

Fig.3